# EUROPEAN PATENT APPLICATION

(11) **EP 3 076 446 A1**
(43) Date of publication of application: **05.10.2016**
(21) Application number: 14865708.3
(22) Date of filing: 24.10.2014
(51) Int. Cl.: H01L 35/32, C25B 1/02

(54) **HYBRID TYPE DEVICE**

(30) Priority: 27.11.2013 KR 20130145532
(71) Applicant: Industry-university Cooperation Foundation Hanyang, Ansan-si, Gyeonggi-do 426-791 (KR)
(72) Inventor: LEE, Jung-Ho, Seoul 137-797 (KR); SHIN, Sun-Mi, Seoul 157-845 (KR); JUNG, Jin-Young, Ulsan 683-753 (KR); PARK, MinJoon, Seoul 121-821 (KR)
(74) Representative: Schwarz & Partner
(86) International application number: PCT/KR2014/010050
(87) International publication number: WO 2015/080382

(57) **Abstract**

Disclosed is a hybrid device for combining a photoelectrochemical cell and a thermoelectric element to generate hydrogen and power. The hybrid device includes: a heat source; a thermoelectric element connected to the heat source and driven by the heat source to generate a first electromotive force; and a photoelectrochemical cell connected to the thermoelectric element to receive the first electromotive force, receiving light to generate a second electromotive force, generating hydrogen by the first electromotive force and the second electromotive force, and being cooled by the thermoelectric element.

## Description

### BACKGROUND OF THE INVENTION

### (a) Field of the Invention

This application claims priority to and the benefit of Korean Patent Application No. 10-2013-0145532 filed in the Korean Intellectual Property Office on November 27, 2013, the entire contents of which are incorporated herein by reference.

The present invention relates to a hybrid device. In further detail, the present invention relates to a hybrid device for combining a photoelectrochemical cell and a thermoelectric element and generating hydrogen and power.

### (b) Description of the Related Art

In general, regarding a photoelectrochemical cell, semiconductor materials such as MoSe₂, CdSe, GaAs, InP, WSe₂, CuInSe₂, or Si may be used as materials for anodes and cathodes. When the semiconductor material is used as the material of the cathode, an aqueous solution of H₂SO₄ or HF with a low pH as an electrolyte is used. Further, when the semiconductor material is used as the cathode, an aqueous solution of NaOH with a high pH as an electrolyte is used. Hydrolysis by photoelectrochemistry may be performed by applying a relatively low voltage from the outside compared to the hydrolysis by electrochemistry.

Regarding the photoelectrochemical cell, noble metal particles such as platinum are deposited on silicon and are then used in order to efficiently absorb light and use it for electrolysis of water. However, cost competitiveness is deteriorated because of a high production expense caused by the use of a noble metal, and the light is not fluently absorbed to thus reduce a photocurrent.

### SUMMARY OF THE INVENTION

The present invention has been made in an effort to provide a hybrid device for combining a photoelectrochemical cell and a thermoelectric element and generating hydrogen and power.

An exemplary embodiment of the present invention provides a hybrid device including: a heat source; a thermoelectric element connected to the heat source and driven by the heat source to generate a first electromotive force; and a photoelectrochemical cell connected to the thermoelectric element to receive the first electromotive force, receiving light to generate a second electromotive force, generating hydrogen by the first electromotive force and the second electromotive force, and being cooled by the thermoelectric element.

The photoelectrochemical cell may include: a first electrode for receiving the light and generating the second electromotive force; an electrolyte contacting the first electrode; and a second electrode contacting the electrolyte. The thermoelectric element may include: a high temperature portion connected to the heat source; a low temperature portion separated from the high temperature portion to face the high temperature portion, and connected to the first electrode; and at least one p-type semiconductor element and at least one n-type semiconductor element separated from each other and positioned between the high temperature portion and the low temperature portion. The first electrode may be electrically connected to the p-type semiconductor element, and the second electrode may be electrically connected to the n-type semiconductor element.

The hybrid device may further include a cooling line for connecting the first electrode and the low temperature portion. The heat source may be included in a vehicle.

Another embodiment of the present invention provides a hybrid device including: a thermoelectric element for generating a first electromotive force; and a photoelectrochemical cell connected the thermoelectric element to receive the first electromotive force, and receiving light to generate a second electromotive force, and generating hydrogen by the first electromotive force and the second electromotive force. A resistance ratio of the thermoelectric element to the photoelectrochemical cell may be about 0.010 to about 0.105. Further desirably, the resistance ratio of the thermoelectric element to the photoelectrochemical cell may be about 0.010 to about 0.056. Most desirably, the resistance ratio of the thermoelectric element to the photoelectrochemical cell may be about 0.010 to about 0.021.

Resistance of the thermoelectric element may be about 1.9 Ω to about 4.2 Ω. Most desirably, the resistance of the thermoelectric element may be about 1.9 Ω to about 2.1 Ω. Resistance of the photoelectrochemical cell may be about 80 Ω to about 200 Ω.

The photoelectrochemical cell may include: a first electrode receiving the light to generate the second electromotive force; an electrolyte contacting the first electrode; and a second electrode contacting the electrolyte. The thermoelectric element may include: a high temperature portion; a low temperature portion separated from the high temperature portion to face the high temperature portion; and at least one p-type semiconductor element and at least one n-type semiconductor element separated from each other positioned to the high temperature portion and the low temperature portion. The first electrode may be electrically connected to the p-type semiconductor element, and the second electrode may be electrically connected to the n-type semiconductor element.

The high temperature portion may be exposed to the outside so that the light may be incident to the high temperature portion. The high temperature portion may be connected to the first electrode to receive heat generated by the first electrode. The light may be incident to the electrolyte to heat the electrolyte, and the high temperature portion may neighbor the electrolyte to receive heat generated by the electrolyte. The first electrode may include silicon, and the silicon may be uncoated and may contact the outside. A surface of the silicon may be textured or a nanostructure may be formed on the surface of the silicon.

Hydrogen and power may be generated by a combination of the photoelectrochemical cell and the thermoelectric element. Therefore, the energy use efficiency of the hybrid device may be maximized.

### BRIEF DESCRIPTION OF THE DRAWINGS

FIG. 1 to FIG. 4 show a hybrid device according to a first exemplary embodiment to a fourth exemplary embodiment of the present invention.
FIG. 5 shows a current voltage graph of a hybrid device of Experimental Example 1 and a photoelectrochemical cell of Comparative Example 1.
FIG. 6 shows a current voltage graph of a hybrid device according to changes of a temperature difference of a thermoelectric element included in a hybrid device of Experimental Example 1.
FIG. 7 shows a current voltage graph of a hybrid device according to changes of a temperature difference of a thermoelectric element included in a hybrid device of Experimental Example 2.
FIG. 8 shows an efficiency change graph of a photoelectrochemical cell according to changes of a temperature difference of a thermoelectric element included in a hybrid device of Experimental Example 1 and Experimental Example 2.

### DETAILED DESCRIPTION OF THE EMBODIMENTS

When a part is referred to as being "on" another part, it can be directly on the other part or intervening parts may also be present. In contrast, when an element is referred to as being "directly on" another element, there are no intervening elements therebetween.

It will be understood that, although the terms first, second, third, etc. may be used herein to describe various elements, components, regions, layers, and/or sections, they are not limited thereto. These terms are only used to distinguish one element, component, region, layer, or section from another element, component, region, layer, or section. Thus, a first element, component, region, layer, or section discussed below could be termed a second element, component, region, layer, or section without departing from the teachings of the present invention.

The technical terms used herein are to simply mention a particular exemplary embodiment and are not meant to limit the present invention. An expression used in the singular encompasses the expression of the plural, unless it has a clearly different meaning in the context. In the specification, it is to be understood that the terms such as "including" or "having" etc., are intended to indicate the existence of specific features, regions, numbers, stages, operations, elements, components, or combinations thereof disclosed in the specification, and are not intended to preclude the possibility that one or more other specific features, regions, numbers, operations, elements, components, or combinations thereof may exist or may be added.

Spatially relative terms, such as "below", "above", and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the drawings. For example, if the device in the figures is turned over, elements described as "below" other elements or features would then be oriented "above" the other elements or features. Thus, the exemplary term "below" can encompass both an orientation of above and below. Devices may be otherwise rotated about 90 degrees or at other angles and the spatially relative descriptors used herein are to be interpreted accordingly.

Unless otherwise defined, all terms used herein, including technical or scientific terms, have the same meanings as those generally understood by those with ordinary knowledge in the field of art to which the present invention belongs. Such terms as those defined in a generally used dictionary are to be interpreted to have the meanings equal to the contextual meanings in the relevant field of art, and are not to be interpreted to have idealized or excessively formal meanings unless clearly defined in the present application.

The present invention will be described more fully hereinafter with reference to the accompanying drawings, in which exemplary embodiments of the invention are shown. As those skilled in the art would realize, the described embodiments may be modified in various different ways, all without departing from the spirit or scope of the present invention.

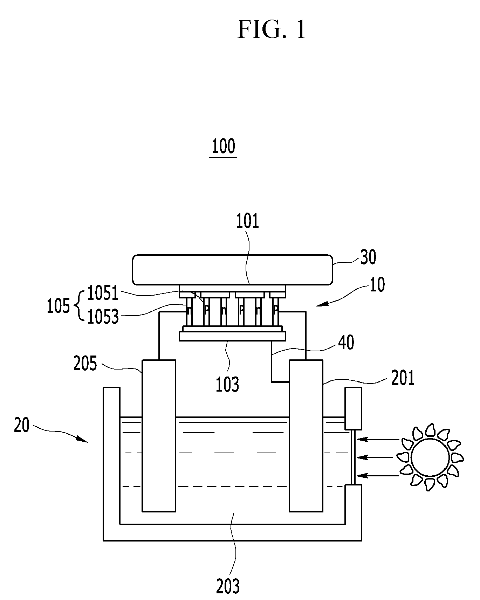

FIG. 1 shows a hybrid device 100 according to a first exemplary embodiment of the present invention. A configuration of the hybrid device 100 shown in FIG. 1 exemplifies the present invention, and the present invention is not limited thereto. Therefore, the configuration of the hybrid device 100 is modifiable.

As shown in FIG. 1, the hybrid device 100 includes a thermoelectric element 10, a photoelectrochemical cell 20, and a heat source 30. The hybrid device 100 may further include other components.

The thermoelectric element 10 includes a high temperature portion 101, a low temperature portion 103, and a semiconductor element 105. The high temperature portion 101 is connected to the heat source 30 to receive heat. Therefore, an electromotive force is generated by a Seebeck effect caused by a temperature difference with the low temperature portion 103. That is, free electrons acquire energy by heat, and the electromotive force is generated by use of the energy. For this, the semiconductor element 105 connects the high temperature portion 101 and the low temperature portion 103. The semiconductor element 105 includes a p-type semiconductor element 1051 and an n-type semiconductor element 1053. At least one p-type semiconductor element 1051 and n-type semiconductor element 1053 are disposed to be separate from each other. In order to increase a generation voltage of the thermoelectric element 10, a plurality of p-type semiconductor elements 1051 and n-type semiconductor elements 1053 are usable. For example, a total number of a plurality of p-type semiconductor elements 1051 and n-type semiconductor elements 1053 may be 142 to 254. That is, by connecting a plurality of p-type semiconductor elements 1051 and n-type semiconductor elements 1053 in series, a high voltage may be generated and may be supplied to the photoelectrochemical cell 20 when the temperature difference between the high temperature portion 101 and the low temperature portion 103 is the same. A detailed description on the thermoelectric element 10 may be easily understood by a skilled person in the art, so it will be omitted.

The heat source 30 is connected to the thermoelectric element 10, that is, the high temperature portion 101 of the thermoelectric element 10, to supply heat to the high temperature portion 101. Although not shown in FIG. 1, the heat source 30 may be included in a vehicle. That is, the heat source 30 may be attached to an outside or inside of the vehicle to be used. For example, an engine or exhaust portion of the vehicle may be exemplified as the heat source 30. A temperature at this portion exceeds about 400 °C so sufficient heat to operate the thermoelectric element 10 may be supplied. Waste heat or geothermal power of a power plant as well as the vehicle may be used as a heat source.

As shown in FIG. 1, the photoelectrochemical cell 20 includes a first electrode 201, an electrolyte 203, and a second electrode 205. The photoelectrochemical cell 20 may further include other constituent elements. The photoelectrochemical cell 20 is connected to the thermoelectric element 10. That is, the n-type semiconductor element 1053 is electrically connected to the second electrode 205, and the p-type semiconductor element 1051 is electrically connected to the first electrode 201. When the first electrode 201 is a cathode, the second electrode 205 may be an anode. In another way, when the first electrode 201 is an anode, the second electrode 205 may be a cathode.

As shown in FIG. 1, the electromotive force generated by the thermoelectric element 10 according to the temperature difference between the high temperature portion 101 and the low temperature portion 103 by the heat source 30 may be supplied to the photoelectrochemical cell 20 through the p-type semiconductor element 1051 and the n-type semiconductor element 1053 to manufacture hydrogen. The first electrode 201 may include silicon. When the first electrode 201 is formed to be uncoated without being coated with a noble metal such as platinum, the photoelectrochemical cell 20 receives the electromotive force from the thermoelectric element 10 thereby acquiring sufficient power for electrolyzing the electrolyte 203. In order to improve photoelectric conversion efficiency of the first electrode 201, a surface of the silicon may be textured or a nanostructure may be formed on the surface of the silicon. As a result, a surface area of the silicon may be widened to maximize light absorption so the photoelectric conversion efficiency of the first electrode 201 may be increased.

When the electrolyte is electrolyzed with another electromotive force generated by a photoelectric conversion through the first electrode 201 and the second electrode 205 and the electromotive force supplied from the thermoelectric element 10, oxygen is generated on a surface of the second electrode 205 according to an electrochemical reaction, hydrogen is generated on a surface of the first electrode 201, and they are collected and then used as a fuel. For example, a fuel cell vehicle uses hydrogen as the fuel so the hydrogen may be supplied to the fuel cell vehicle.

By connecting the first electrode 201 and the low temperature portion 103, deterioration of the first electrode 201 may be prevented by the low temperature portion 103. That is, the temperature of the low temperature portion 103 is low so the first electrode 201 may be cooled by using a cooling line 40 connecting the first electrode 201 and the low temperature portion 103. The cooling line 40 may be formed to be long. Differing from this, the first electrode 201 may be cooled by directly contacting the low temperature portion 103 and the first electrode 201. The first electrode 201 is cooled so the electromotive force generated by light may be maximized and the electromotive force generated by the photoelectrochemical cell 20 may be increased. A detailed configuration of the photoelectrochemical cell 20 except the above-described content may be easily understood by a skilled person in the art and no detailed description thereof will be provided.

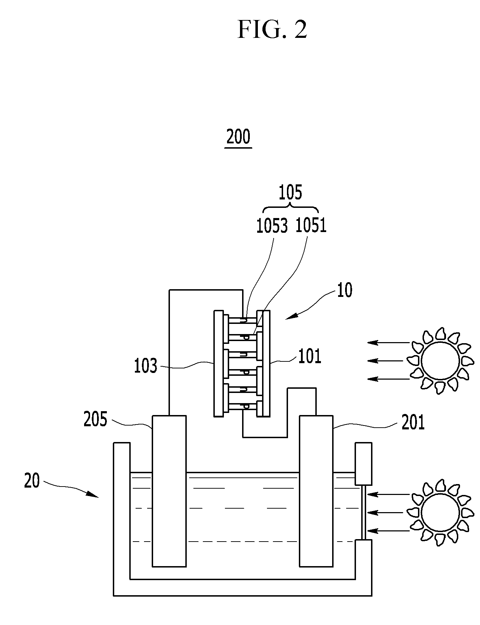

FIG. 2 shows a hybrid device 200 according to a second exemplary embodiment of the present invention. A configuration of the hybrid device 200 shown in FIG. 2 exemplifies the present invention, and the present invention is not limited thereto. Therefore, the configuration of the hybrid device 200 is modifiable. The configuration of the hybrid device 200 shown in FIG. 2 is similar to the configuration of the hybrid device 100 shown in FIG. 1 so like portions use like reference numerals and a detailed description thereof will be omitted.

As shown in FIG. 2, the high temperature portion 101 may be exposed to the outside so that light may be incident to the high temperature portion 101. Therefore, the thermoelectric element 10 may generate the electromotive force by increasing the temperature difference between the high temperature portion 101 and the low temperature portion 103, and hydrogen may be generated from the photoelectrochemical cell 20 by supplying the generated electromotive force to the photoelectrochemical cell 20. In this case, the efficiency of the hybrid device 200 may be maximized by using the thermoelectric element 10 with high resistance. The resistance of the thermoelectric element 10 is very low compared to the resistance of the photoelectrochemical cell 20, which may minimize a negative influence of the thermoelectric element 10 applied to the photoelectrochemical cell 20. That is, when the photoelectrochemical cell 20 is connected to the thermoelectric element 10, a current flows to the photoelectrochemical cell 20, and an overvoltage for generating a current to the photoelectrochemical cell 20 is generated by the thermoelectric element 10. Therefore, a thermoelectric element 10 having low efficiency because of a low current may be efficiently used.

To increase the electromotive force of the thermoelectric element 10, a plurality of p-type semiconductor elements 1051 and a plurality of n-type semiconductor elements 1051 are coupled in series. However, when the number of the p-type semiconductor elements 1051 and a plurality of n-type semiconductor elements 1051 connected in series increases, resistance of the thermoelectric element 10 increases. Therefore, when the thermoelectric element 10 generates a very high voltage and a power loss caused by resistance is large, the thermoelectric element 10 generates low power. However, when a high resistance element such as the photoelectrochemical cell 20 is combined with the thermoelectric element 10 to drive the hybrid device 200, the loss caused by resistance of the thermoelectric element 10 does not become large. Particularly, compared to the combination of a solar cell and the thermoelectric element 10, the combination of the photoelectrochemical cell 20 and the thermoelectric element 10 may further reduce the loss caused by resistance of the thermoelectric element 10. That is, a general solar cell has resistance that is equal to or less than about 1 Ω, and the thermoelectric element has resistance that is about 1-2 Ω and is higher than that of the solar cell. In this case, the resistance that is raised by the thermoelectric element generates a great loss when the solar cell is driven.

On the contrary to this, resistance of the photoelectrochemical cell 20 is about 50 Ω to about 200 Ω which is substantially 100 times higher than that of the thermoelectric element 10. Therefore, resistance between before and after the photoelectrochemical cell 20 and the thermoelectric element 10 are connected in series is very much less so power consumption caused by the resistance of the thermoelectric element 10 is not large. Therefore, the hybrid element 200 with the combination of the photoelectrochemical cell 20 and the thermoelectric element 10 may use the voltage generated by the temperature difference without the loss caused by the resistance of the thermoelectric element 10.

Electrical conductivity of the solid solar cell or the thermoelectric element is determined by mobility of electrons and holes, and the electrical conductivity of the liquid electrolyte is determined by ions. Therefore, the photoelectrochemical cell has higher resistance than the solid solar cell or the thermoelectric element since it conducts in the liquid electrolyte.

For this purpose, a resistance ratio of the thermoelectric element 10 to the photoelectrochemical cell 20 may be about 0.010 to about 0.105. When the resistance ratio of the thermoelectric element 10 to the photoelectrochemical cell 20 is very large, a characteristic of the photoelectrochemical cell 20 may be deteriorated because of resistance of the thermoelectric element 10. Therefore, a resistance difference between the thermoelectric element 10 and the photoelectrochemical cell 20 is controlled to be within the above-noted range. Desirably, the resistance ratio of the thermoelectric element 10 to the photoelectrochemical cell 20 may be about 0.010 to about 0.056. Further desirably, the resistance ratio of the thermoelectric element 10 to the photoelectrochemical cell 20 may be about 0.010 to about 0.021.

The resistance of the thermoelectric element 10 may be about 1.9 Ω to about 4.2 Ω. Further desirably, the resistance of the thermoelectric element 10 may be about 1.9 Ω to about 2.1 Ω. When resistance of the thermoelectric element 10 is very large, driving efficiency of the thermoelectric element 10 may be deteriorated. Lowering the resistance is limited because of a characteristic of a material of the thermoelectric element 10. Therefore, it is desirable to control the resistance of the thermoelectric element 10 to be within the above-noted range.

The resistance of the photoelectrochemical cell 20 may be about 80 Ω to about 200 Ω. In this case, silicon may be used as a material of the photoelectrochemical cell 20. When the resistance of the photoelectrochemical cell 20 is very high, the driving efficiency of the photoelectrochemical cell 20 is deteriorated, and when the resistance of the photoelectrochemical cell 20 is very low, the characteristic of the hybrid device 200 is deteriorated because of internal resistance of the thermoelectric element 10. Therefore, it is desirable to control the resistance of the photoelectrochemical cell 20 to be within the above-noted range. As described above, energy conversion efficiency of the hybrid device 200 may be maximized by controlling the resistance of the thermoelectric element 10 and the resistance of the photoelectrochemical cell 20.

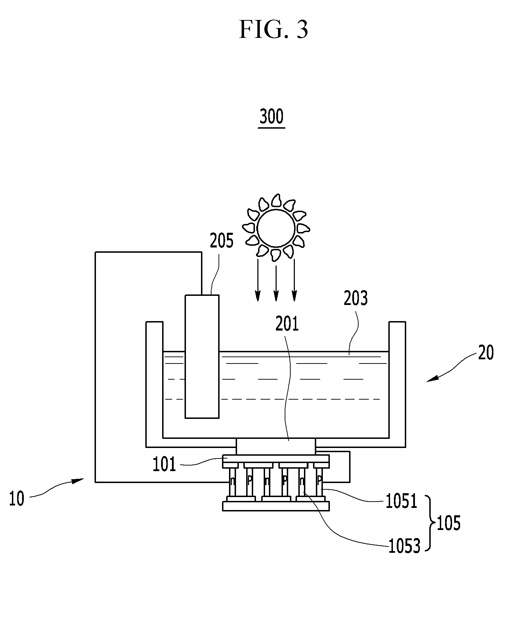

FIG. 3 shows a hybrid device 300 according to a third exemplary embodiment of the present invention. A configuration of the hybrid device 300 shown in FIG. 3 exemplifies the present invention, and the present invention is not limited thereto. Therefore, the configuration of the hybrid device 300 is modifiable. The configuration of the hybrid device 300 shown in FIG. 3 is similar to the configuration of the hybrid device 200 shown in FIG. 2, so like portions use like reference numerals and a detailed description thereof will be omitted.

As shown in FIG. 3, the high temperature portion 101 of the thermoelectric element 10 contacts the first electrode 201 of the photoelectrochemical cell 20 to receive heat generated by the first electrode 201 by light. The first electrode 201 generates the electromotive force by light passing through the electrolyte 203 so hydrogen may be manufactured from the photoelectrochemical cell 20 by use of the electromotive force. The electromotive force is generated in the thermoelectric element 10 by the temperature difference between the high temperature portion 101 heated by the first electrode 201 and the low temperature portion 103, and it is transmitted to the photoelectrochemical cell 20. For this, the first electrode 201 is electrically connected to the p-type semiconductor element 1051, and the second electrode 205 is electrically connected to the n-type semiconductor element 1053. As a result, the photoelectrochemical cell 20 may provide a sufficient electromotive force for generating hydrogen.

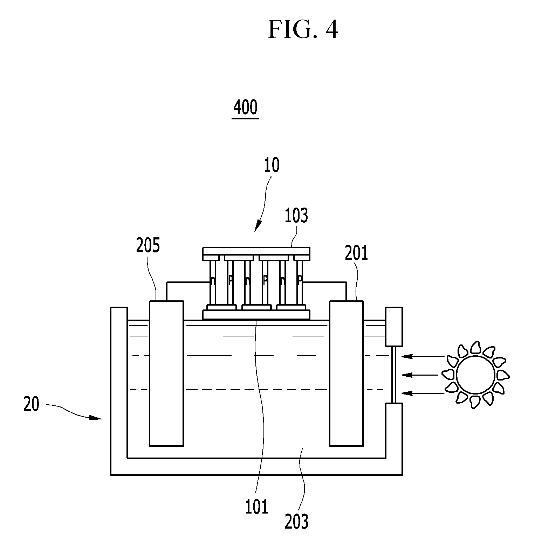

FIG. 4 shows a hybrid device 400 according to a fourth exemplary embodiment of the present invention. A configuration of the hybrid device 400 shown in FIG. 4 exemplifies the present invention, and the present invention is not limited thereto. Therefore, the configuration of the hybrid device 400 is modifiable. The configuration of the hybrid device 400 shown in FIG. 4 is similar to the configuration of the hybrid device 200 shown in FIG. 2, so like portions use like reference numerals and a detailed description thereof will be omitted.

As shown in FIG. 4, the high temperature portion 101 may neighbor the electrolyte 203 and may receive heat generated by the electrolyte 203. That is, light is incident to the electrolyte 203 to heat the electrolyte 203, so the high temperature portion 101 may receive the heat and the temperature difference with the low temperature portion 103 may be increased. In this case, the electromotive force is generated in the thermoelectric element 10 and is supplied to the photoelectrochemical cell 20 so the photoelectrochemical cell 20 may continuously generate a sufficient amount of hydrogen.

The present invention will be described in detail with experimental examples. The experimental examples are provided to exemplify the present invention and the present invention is not limited thereto.

### Experimental Example 1

The experiment is performed with a thermoelectric element with internal resistance of 1.2 Ω, 142 legs, and the Seebeck coefficient of 0.019 V/K. Here, the legs are manufactured using bismuth telluride (BiTe). A photocathode of the photoelectrochemical cell is manufactured with a p-type silicon wafer, the silicon wafer is 500 µm thick, and its resistivity is 1 to 10 Ωcm. A sulfuric acid of 0.5 M is used as the electrolyte of the photoelectrochemical cell, and Pt or Ag/AgCl is used as the anode.

### Experimental Example 2

The experiment is performed with a thermoelectric element with internal resistance of 2.1 Ω, 254 legs, and the Seebeck coefficient of 0.025 V/K. Here, the legs are manufactured using bismuth telluride (BiTe). Other experimental processes correspond to the above-described Experimental Example 1.

### Comparative Example 1

The photoelectrochemical cell used in the Experimental Example 1 is used.

### Current voltage measuring experiment and result

The thermoelectric element and the photoelectrochemical cell shown in the Experimental Example 1 are connected to the hybrid device of FIG. 2, and a current density caused by generation of a voltage is measured. Further, the current density caused by the generation of a voltage of the photoelectrochemical cell is measured using the same method as the above-described Experimental Example 1.

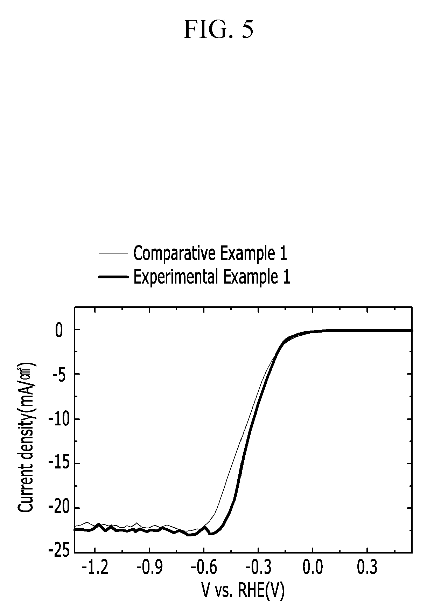

FIG. 5 shows a current voltage graph of a hybrid device of Experimental Example 1 and a photoelectrochemical cell of Comparative Example 1. In FIG. 5, a thick line represents Experimental Example 1, and a thin line indicates Comparative Example 1.

As shown in FIG. 5, regarding Experimental Example 1, the current density caused by the voltage may be raised when the voltage is further raised compared to Comparative Example 1. However, the difference is very small so the efficiency is rarely deteriorated compared to the case in which the hybrid device uses the photoelectrochemical cell.

### Current voltage measuring experiment according to internal temperature difference of thermoelectric element and its result

### Experiment and result on Experimental Example 1

Changes of voltage and current of the hybrid device are measured by controlling a temperature difference between the high temperature portion and the low temperature portion of the thermoelectric element of Experimental Example 1.

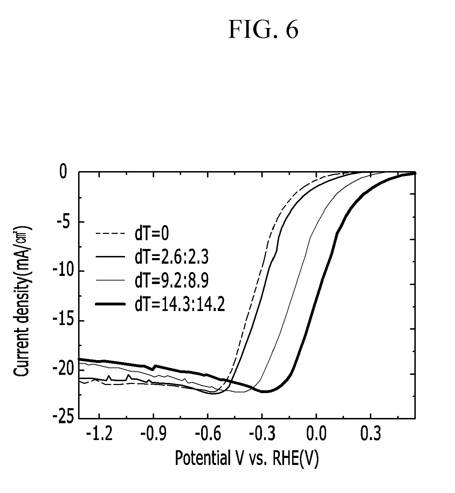

FIG. 6 shows a current and voltage graph of a hybrid device according to changes of a temperature difference of a thermoelectric element included in a hybrid device of Experimental Example 1. In FIG. 6, the experiment is performed by controlling the temperature difference to be 0, 2.3 to 2.6, 8.9 to 9.2, and 14.2 to 14.3.

In FIG. 6, a current value represents that the electrolyte is used to the electrolysis, and it is found that the current value at 0 V becomes bigger as the temperature difference becomes bigger. That is, as the current value becomes bigger, the electrolysis of water is activated without the voltage applied from the outside.

### Experiment and result on Experimental Example 2

Changes of voltage and current of the hybrid device is measured by controlling a temperature difference between the high temperature portion and the low temperature portion of the thermoelectric element of Experimental Example 2.

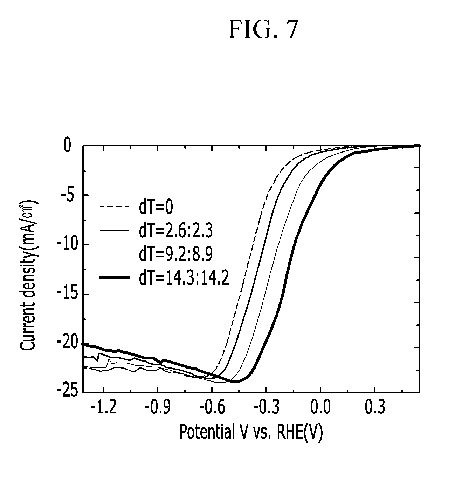

FIG. 7 shows a current voltage graph of a hybrid device according to changes of a temperature difference of a thermoelectric element included in a hybrid device of Experimental Example 2. In FIG. 7, the experiment is performed by controlling the temperature difference to be 0, 3 to 3.5, 6.4 to 6.7, and 16.2 to 16.4.

As shown in FIG. 7, it is found that the current value at 0 V becomes bigger as the temperature difference becomes bigger. That is, as the current value becomes bigger, the electrolysis of water is activated without the voltage applied from the outside. However, a movement distance of the graph is reduced depending on the temperature difference, which is because the number of thermoelectric elements used in Experimental Example 2 is less than the number of thermoelectric elements in Experimental Example 1 so the generated amount of voltage is small when the temperature difference is the same.

### Efficiency experiment of photoelectrochemical cell and its result

Changes of efficiency of the photoelectrochemical cell included in the hybrid device according to the change of the temperature difference between the thermoelectric elements of Experimental Example 1 and Experimental Example 2 are measured.

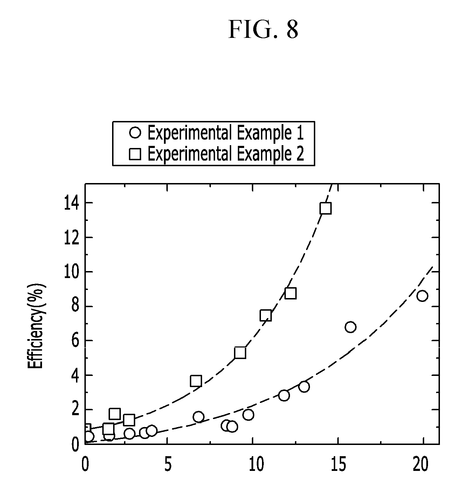

FIG. 8 shows an efficiency change graph of a photoelectrochemical cell according to changes of a temperature difference of a thermoelectric element included in a hybrid device of Experimental Example 1 and Experimental Example 2. In FIG. 8, the temperature difference of the thermoelectric elements of Experimental Example 1 and Experimental Example 2 are controlled to correspond to the above-described experiment for measuring the current and the voltage. In FIG. 8, a circular shape represents a thermoelectric element included in the hybrid device manufactured according to Experimental Example 1, and a quadrangular shape indicates a thermoelectric element included in the hybrid device manufactured according to Experimental Example 2.

As shown in FIG. 8, as the temperature difference becomes bigger, the efficiency of the photoelectrochemical cell is increased in proportion to it. Further, when the thermoelectric element of Experimental Example 2 with many legs is used, the efficiency of the photoelectrochemical cell is substantially increased compared to the case of using the thermoelectric element of Experimental Example 1.

### Experiment for measuring resistance difference between thermoelectric element and photoelectrochemical cell

Changes of the current and the voltage of the hybrid device according to the change of resistance while changing the resistance of the thermoelectric element and the resistance of the photoelectrochemical cell are measured. Table 1 expresses a hybrid device manufactured according to Experimental Example 3 to Experimental Example 14 and corresponding characteristic values.

Regarding Experimental Example 3 to Experimental Example 14, resistance (A) is changed by changing the number of legs of the thermoelectric element or according to a connection in series, and the photoelectrochemical cell changes resistance (B) by controlling a distance between electrodes. A method for changing the resistance of the thermoelectric element or the photoelectrochemical cell may be easily understood by a person skilled in the art so no detailed description thereof will be provided.

**(Table 1)**

| No | Experimental Examples | Resistance (A) of thermoelectric element | Resistance (B) of photoelectrochemical cell | A/B | Current density of electrochemical cell vs. Current density of hybrid element |
|---|---|---|---|---|---|
| 1 | Experimental Example 3 | 2.1 | 18 | 0.117 | 89.6 % |
| 2 | Experimental Example 4 | 1.9 | 18 | 0.105 | 90.5 % |
| 3 | Experimental Example 5 | 4.2 | 80 | 0.056 | 95.0 % |
| 4 | Experimental Example 6 | 3.8 | 80 | 0.048 | 95.5 % |
| 5 | Experimental Example 7 | 1.9 | 100 | 0.019 | 98.2 % |
| 6 | Experimental Example 8 | 1.9 | 200 | 0.010 | 99.1 % |
| 7 | Experimental Example 9 | 2.1 | 200 | 0.011 | 99.0 % |
| 8 | Experimental Example 10 | 2.1 | 100 | 0.021 | 97.9 % |
| 9 | Experimental Example 11 | 3.8 | 50 | 0.076 | 92.9 % |
| 10 | Experimental Example 12 | 4.2 | 50 | 0.084 | 92.3 % |
| 11 | Experimental Example 13 | 3.8 | 18 | 0.211 | 82.6 % |
| 12 | Experimental Example 14 | 4.2 | 18 | 0.233 | 81.1 % |

As expressed in Table 1, relatively good values of the current density are obtained in Experimental Example 4 to Experimental Example 12. Therefore, when the resistance ratio of the thermoelectric element to the photoelectrochemical cell is controlled in a like manner of Experimental Example 4 to Experimental Example 12, the efficiency of the hybrid device may be optimized. Further desirably, when the resistance ratio of the thermoelectric element to the photoelectrochemical cell is controlled in a like manner of Experimental Example 5 to Experimental Example 10, the efficiency of the hybrid device may be further optimized. The most desirably, when the resistance ratio of the thermoelectric element to the photoelectrochemical cell is controlled in a like manner of Experimental Example 7 to Experimental Example 9, the efficiency of the hybrid device may be most optimized. That is, the condition for optimizing the current density of the hybrid device may be acquired through the above-described Experimental Example 3 to Experimental Example 14.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A hybrid device comprising:
a heat source;
a thermoelectric element connected to the heat source and driven by the heat source to generate a first electromotive force; and
a photoelectrochemical cell connected to the thermoelectric element to receive the first electromotive force, receiving light to generate a second electromotive force, generating hydrogen by the first electromotive force and the second electromotive force, and being cooled by the thermoelectric element,
wherein the photoelectrochemical cell includes
a first electrode for receiving the light and generating the second electromotive force,
an electrolyte contacting the first electrode, and
a second electrode contacting the electrolyte,
the thermoelectric element includes
a high temperature portion connected to the heat source,
a low temperature portion separated from the high temperature portion to face the high temperature portion, and connected to the first electrode,
at least one p-type semiconductor element and at least one n-type semiconductor element separated from each other and positioned between the high temperature portion and the low temperature portion, and
the first electrode is electrically connected to the p-type semiconductor element, and the second electrode is electrically connected to the n-type semiconductor element.

2. The hybrid device of claim 1, further comprising
a cooling line for connecting the first electrode and the low temperature portion.

3. The hybrid device of claim 1, wherein
the heat source is included in a vehicle.

4. A hybrid device comprising:
a thermoelectric element for generating a first electromotive force; and
a photoelectrochemical cell connected the thermoelectric element to receive the first electromotive force, receiving light to generate a second electromotive force, and generating hydrogen by the first electromotive force and the second electromotive force,
wherein a resistance ratio of the thermoelectric element to the photoelectrochemical cell is about 0.010 to about 0.105.

5. The hybrid device of claim 4, wherein
the resistance ratio of the thermoelectric element to the photoelectrochemical cell is about 0.010 to about 0.056.

6. The hybrid device of claim 5, wherein
the resistance ratio of the thermoelectric element to the photoelectrochemical cell is about 0.010 to about 0.021.

7. The hybrid device of claim 4, wherein
resistance of the thermoelectric element is about 1.9 Ω to about 4.2 Ω.

8. The hybrid device of claim 7, wherein
the resistance of the thermoelectric element is about 1.9 Ω to about 2.1 Ω.

9. The hybrid device of claim 7, wherein
the resistance of the photoelectrochemical cell is about 80 Ω to about 200 Ω.

10. The hybrid device of claim 4, wherein
the photoelectrochemical cell includes:
a first electrode receiving the light to generate the second electromotive force;
an electrolyte contacting the first electrode; and
a second electrode contacting the electrolyte,
the thermoelectric element includes:
a high temperature portion;
a low temperature portion separated from the high temperature portion to face the high temperature portion; and
at least one p-type semiconductor element and at least one n-type semiconductor element separated from each other and positioned between the high temperature portion and the low temperature portion, and
the first electrode is electrically connected to the p-type semiconductor element, and the second electrode is electrically connected to the n-type semiconductor element.

11. The hybrid device of claim 10, wherein
the high temperature portion is exposed to the outside so that the light is incident to the high temperature portion.

12. The hybrid device of claim 10, wherein
the high temperature portion is connected to the first electrode to receive heat generated by the first electrode.

13. The hybrid device of claim 10, wherein
the light is incident to the electrolyte to heat the electrolyte, and the high temperature portion neighbors the electrolyte to receive heat generated by the electrolyte.

14. The hybrid device of claim 1 or claim 10, wherein
the first electrode includes silicon, and the silicon is uncoated and contacts the outside.

15. The hybrid device of claim 15, wherein
a surface of the silicon is textured, or a nanostructure is formed on the surface of the silicon.
